# EUROPEAN PATENT APPLICATION

(11) **EP 1 043 833 A1**
(43) Date of publication of application: **11.10.2000**
(21) Application number: 99302689.7
(22) Date of filing: 07.04.1999
(51) Int. Cl.: H03G 3/30

(54) **RF power control loop with variable loop filter**

(71) Applicant: LUCENT TECHNOLOGIES INC., Murray Hill, New Jersey 07974-0636 (US)
(72) Inventor: Van Amerom, Johannes Herman, 2811 JD Reeuwijk (NL)
(74) Representative: Williams, David John

(57) **Abstract**

There is disclosed an RF power control loop (40) comprising: a power amplifier (2) for producing at an output an RF output power signal (22); detection means (6) having an input coupled to the RF output power signal and for generating at an output a detection signal (32) indicative of the RF power level of the RF output power signal; reference means for generating a reference signal (24) indicative of the required power level of the RF output power signal to be output by the power amplifier; comparison means (44) connected to receive the detection signal and the reference signal and for outputting a control signal (30) to the power amplifier, wherein the control signal adjusts the RF power level of the RF output power signal in dependence on the difference between the reference signal and the detection signal, and wherein the comparison means includes a loop filter having at least two selectable bandwidths, the bandwidths of the loop filter being selected responsive to the required power level of the RF output power signal.

## Description

### Field of the Invention

The present invention relates to improvements in RF power control loops, and particularly but not exclusively in RF power control loops suitable for generation of burst transmissions in GSM mobile stations.

### Background to the Invention

In a GSM system a mobile station generates transmission bursts (or power bursts) at regular intervals. The transmission bursts are used in order to get an initial RF output power to the antenna with a defined shape and output level in a certain time frame.

These transmission bursts are generated in a predetermined timing slot and are used by base stations to determine the distance of the mobile station relative to the base station. On detection of a transmission burst from a mobile station the base station sends control signals to the mobile stations. These control signals contain various control information for the mobile station. For instance, the mobile station may be instructed to adjust the timing or power level of the transmission bursts in dependence on the relative distance of the mobile station to the base station. As the mobile station gets closer to the base station the timing of the transmission burst needs to be adjusted such that it arrives at the base station in the correct time slot. Similarly, the nearer the mobile station is to the base station the less powerful the signal level of the transmission burst is required to be. The generation and control of transmission bursts will be familiar to one knowledgeable in the art of GSM mobile communications.

In summary, there are two fundamental parameters to be considered in designing a RF power loop for a GSM system in respect of the transmission burst:
1. The RF output power level of the transmission burst; and
2. The timing position of the transmission burst

It is generally difficult to maintain the correct power/timing template of the transmission burst in a GSM system over the required range of operational temperatures and RF output power levels. In the ETS (European Telecommunications Standard) GSM900 phase II standard the lowest output power requirement is 5dBm (3.2mW in a 50Ω load) over a temperature range of -10°C up to +55°C. In the ETS GSM900 phase I standard the lowest output power requirement is 13 dBm over a required temperature range of -20°C up to +80°C. In the ETS Phase II GSM 900, each transmission burst is 598.8ms long.

In conventional RF power control loops for GSM mobiles there is a performance trade-off between the range of operational power levels and the timing of the transmission burst. Conventional RF power control loops include a loop filter. If such loop filter is designed to have the necessary characteristics for reliable operation at high power levels then the timing of the system may be lost at low power levels. If the loop filter is designed for reliable operation at low power levels, then the system may become unstable at high power levels.

In low cost GSM RF power control loop circuits the control voltage versus RF output power of RF Power Amplifier is usually non-linear (non-linear feed forward). The RF detector, in the feed back circuit, has an output voltage versus RF input voltage that is usually non-linear (non linear feed back). This means that the loop gain for the different RF output power levels is non-linear.

Further, for low power levels in a conventional GSM power control loop the influence of temperature fluctuations is great because output levels of the RF detector in the power control loop are low. This also means that in the low power range, small changes in the input signal caused by temperature fluctuations result in a relatively large change in the output signal.

It is therefore an object of the present invention to provide a low-cost RF power control loop suitable for use in a GSM mobile which provides reliable operation over a full range of possible output power levels, without increasing the technical or build complexity of the power control loop circuit and whilst minimising the space consumed by such improvements.

### Summary of the Invention

According to the present invention there is provided an RF power control loop comprising: a power amplifier for producing at an output an RF output power signal; detection means having an input coupled to the RF output power signal and for generating at an output a detection signal indicative of the RF power level of the RF output power signal; reference means for generating a reference signal indicative of the required power level of the RF output power signal to be output by the power amplifier; comparison means connected to receive the detection signal and the reference signal and for outputting a control signal to the power amplifier, wherein the control signal adjusts the RF power level of the RF output power signal in dependence on the difference between the reference signal and the detection signal, and wherein the comparison means includes a loop filter having at least two selectable bandwidths, the bandwidths of the loop filter being selected responsive to the required power level of the RF output power signal.

The comparison means may include switching means responsive to a power control signal for selecting the bandwidth of the loop filter. The reference signal may vary in response to a variation in temperature in a known manner, and the detection means may further include temperature compensation means adapted to vary the detection signal in the same known manner responsive to a variation in temperature.

The detection means may comprise: a first resistor having a first terminal connected to a reference supply voltage and a second terminal connected to the input; a second resistor having a first terminal connected to the input and a second terminal connected to ground; a first diode having its anode connected to the input and its cathode connected to the output; a second diode, temperature coupled with the first diode, having its anode connected to the output; and a third resistor having a first terminal connected to the cathode of the second diode and a second terminal connected to ground, wherein the temperature compensation means is provided by adapting the ratio of the values of the first, second and third resistors.

The RF power control loop may further comprise amplification means for selectively amplifying the reference signal, wherein the amplification means has at least two selectable amplification factors, the amplification factor of the amplification means being selected responsive to the required power level of the RF output power signal. The amplification circuitry may include switching means responsive to a power control signal for selecting the amplification factor. The amplification factor may be increased if the required power level of the RF output power signal is increased. The RF power control loop may further comprise means for selectively supplying the reference supply voltage.

The reference means for generating the reference signal may comprise: storage means for storing a reference level corresponding to the required power level of the RF output signal; signal generating means connected to the storage means, for generating an intermediate reference signal based on the stored reference level; reference comparison means for comparing the level of the intermediate reference signal with the stored reference level; and control means for generating a modified reference level to cancel the difference between the levels of the intermediate reference signal and the stored reference signal, and for replacing the stored reference level with the modified reference level, wherein the signal generating means generates the reference signal based on the stored modified reference level.

The difference between the detected reference level and the stored reference level may be the result of a temperature effect on the reference signal.

The reference comparison means may additionally include reference detection means for detecting the level of the intermediate reference signal.

The RF power control loop may further comprise a filter for filtering the reference signal, wherein the filter has at least two selectable bandwidths, the bandwidth of the filter being selected responsive to the required power level of the RF output power signal.

The filter may include switching means responsive to a power control signal for selecting the bandwidth of the filter.

The invention also provides a method of controlling the RF power level of an RF output power signal, comprising: generating an RF output power signal; detecting the RF power level of the RF output power signal; generating a detection signal indicative of the detected RF power level; comparing the detection signal and a reference signal indicative of the required power level of the RF output power signal; adjusting the RF power level of the RF output signal in dependence on the difference between the detection signal and the reference signal, wherein the comparison step further includes a filtering step, the filtering step applying one of at least two selectable bandwidths in dependence on the required power level of the RF output power signal.

The reference signal may vary in response to a variation in temperature in a known manner, the method further comprising the step of varying the detection signal in the same known manner responsive to a variation in temperature.

The step of detecting the RF power level of the RF output signal may be carried out by an RF detector comprising: a first resistor having a first terminal connected to a reference supply voltage and a second terminal connected to an input coupled to the output RF power signal; a second resistor having a first terminal connected to the input and a second terminal connected to ground; a first diode having its anode connected to the input (34) and its cathode connected to an output; a second diode, temperature coupled with the first diode, having its anode connected to the output; and a third resistor having a first terminal connected to the cathode of the second diode and a second terminal connected to ground, wherein the step of varying the detection signal in the same known manner comprises determining a ratio of the values of the first, second and third resistors.

The method may further comprise the step of selectively amplifying the reference signal by one of at least two amplification factors in dependence on the required power level of the RF output signal.

The amplification factor may be increased if the required power level of the RF output power signal is increased. The step of generating the reference signal may comprise: storing a reference level corresponding to the required power level of the RF output signal; generating an intermediate reference signal corresponding to the stored reference level; detecting the level of the intermediate reference signal; comparing the detected level of the intermediate reference signal to the stored reference level; responsive to a difference between the stored and intermediate reference levels, replacing the stored reference level with a modified reference level to compensate for the difference between the stored and intermediate reference levels; and generating the reference signal corresponding to the modified stored reference level.

The difference between the stored and intermediate reference levels may be caused by temperature effects on the intermediate reference signal.

The method may further comprise the step of filtering the reference signal, the filtering step applying one of at least two selectable bandwidths in dependence on the required power level of the RF output power signal.

A GSM mobile communication system may include the defined RF power control loop. The defined method may be used to operate GSM mobile communication system.

### Brief Description of the Drawings

Figure 1 illustrates a block diagram of an exemplary known RF power control loop;
Figure 2 illustrates a "power/timing template" for a burst transmission according to one known GSM standard;
Figure 3 illustrates a block diagram of an improved RF power control loop;
Figure 4 illustrates the implementation of elements of the RF power control loop of Figure 1;
Figure 5 illustrates the implementation of elements of the RF power control loop of Figure 3 according to an exemplary implementation;
Figure 6 illustrates the preferred implementation of an RF detector of the RF power control loop of Figure 3;
Figure 7 illustrates an implementation of a temperature compensation feedback arrangement.

### Description Of the Preferred Embodiment

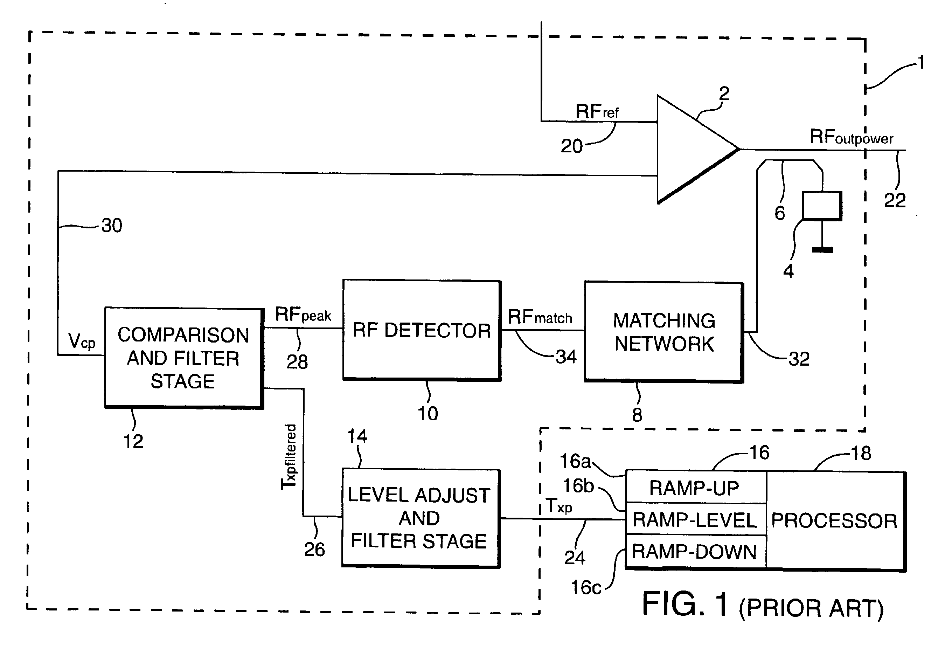

**Figure 1** shows a block schematic of a general, known power control loop circuit 1 for a GSM mobile station.

The power control loop 1 shown in Figure 1 comprises a power stage 2, a directional coupler stage 6, a directional coupler impedance 4, (this is a 50Ω resistor for the reflected waves), a matching network 8, an RF detector stage 10, a comparison and filter stage 12, and a level adjust and filter stage 14. Figure 1 also shows a processor 18 and a set of registers 16 that control the GSM power control loop.

Although in the preferred embodiment a directional coupler is shown as providing detection of the RF output power, other means may be used. In one alternative, a strip line coupler may replace the directional coupler.

The power control loop 1 receives a signal **T**_{**xp**} on line 24 from the registers 16 and an RF input reference signal **RF**_{**ref**} on line 20, and outputs an RF output power signal **RF**_{**outpower**} on line 22. The RF input reference signal **RF**_{**ref**} is a compressed RF signal.

The registers 16 include three registers: a ramp-up register 16a, a ramp-level register 16b, and a ramp-down register 16c. The registers are provided with circuitry, not shown, for selecting the value from one register to output on line 24 as the signal **T**_{**xp**}.

The signal **T**_{**xp**} is the signal that controls the RF output power burst to the antenna that is generated periodically by the mobile station. The registers 16, controlled by the processor 18, determine the shape of the power burst by defining the signal **T**_{**xp**}, and control the power level of the defined signal **T**_{**xp**} The power control loop 1 controls the power level of the RF output power signal **RF**_{**outpower**} as described hereinafter.

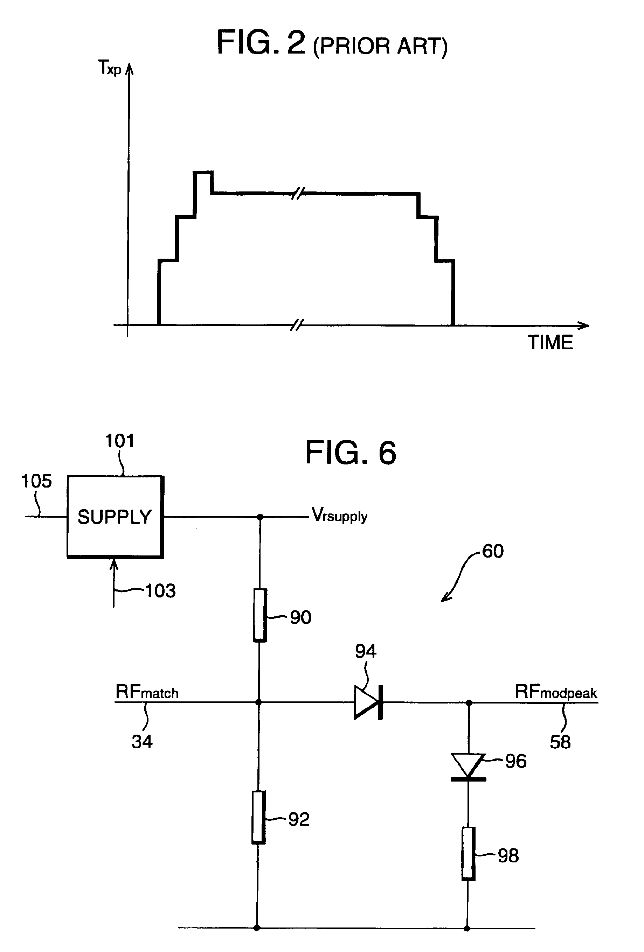

In accordance with the ETS GSM0505 standard, the power burst signal is required to have a ramp shape, and the signal **T**_{**xp**} is therefore created as a ramp. The template within which the required signal shape must fit for this standard is shown in **Figure 2**. The signal shape shown in Figure 2 is called a "power/time template". As seen in Figure 2 the signal **T**_{**xp**} is required to have three distinct phases, a ramp-up portion, a level portion, and a ramp-down portion, which are generated by the values of the registers 16a, 16b, 16c respectively, under the control of the processor 18.

The signal **T**_{**xp**} is thus digitally constructed by the three hardware configured registers 16a, 16b, 16c under the control of the processor 18 with a digital-to-analogue converter (not shown). The ramp-up register 16a and ramp-down register 16c ramp the signal **T**_{**xp**} up and down respectively to get the shape of the slopes. The ramp-level register 16b defines the top value of the RF output power signal **RF**_{**outpower**} to the antenna.

The ramp-up register 16a and the ramp-down register 16c, in the preferred embodiment, store up to 16 numbers each, which each may have a value from 0 to 255. The ramp-level register stores one number in the range from 0 to 255 to define the power level of the signal to the antenna. It will be appreciated by one skilled in the art that the number of ranges provided by the registers 16a, 16b, and 16c can be chosen according to the application, with smaller or larger registers being provided as appropriate.

The signal **T**_{**xp**} on line 24 forms an input to the level adjusting and filtering stage 14. This stage filters the signal **T**_{**xp**} to smooth the rising and falling edges of the slope generated by the registers 16, and outputs a filtered signal **T**_{**xpfiltered**} on line 26. The level adjusting and filtering stage 14 also provides bandpass filtering for the signal **T**_{**xp**}.

The signal **T**_{**xpfiltered**} on line 26 forms a first input to the comparison and filter stage 12. The comparison and filter stage 12 receives a second input **RF**_{**peak**} on line 28 from the RF detector 10, and generates an output signal **V**_{**cp**} on line 30 to the power stage 2. The comparison and filter stage 12 monitors the current power level output to the antenna at the output of the power stage 2 by means of the feedback loop provided by the directional coupler 6, the matching network 8 and the RF detector 10 (described further hereinafter). The comparison and filter stage 12 then maintains the level of the signal **V**_{**cp**} on line 30 to the power stage such that the power level of the output signal on line 22 is maintained at that indicated by the ramp-level register 16b, i.e. the flat level of the signal **T**_{**xpfiltered**} at the input to the comparison and filter stage, which identifies the desired power level of the output power signal **RF**_{**outpower**} to the antenna.

The power stage 2 receives, in addition to the signal **V**_{**cp**}, the RF input reference signal **RF**_{**ref**} as a second input on line 20.

The directional coupler 6 detects the RF power level of the signal **RF**_{**outpower**} output by the power stage 2 on line 22. The RF power level detected is supplied on line 32 to a matching network 8, which in this example is a 50Ω matching network to match the 50Ω impedance 4 of the directional coupler 6. A matched signal **RF**_{**match**} is output on line 34 to the RF detector 10, which detects the peak level output of the power stage 2 and outputs a signal **RF**_{**peak**} on line 28 representing such peak value to the comparison and filter stage 12.

The comparison and filter stage 12 then adjusts the level of the signal **V**_{**cp**} at its output in dependence on whether the peak detected signal **RF**_{**peak**} is different to the required power level determined by the peak level of the signal **T**_{**xpfiltered**} on line 26. Thus the comparison and filter stage 12 outputs a signal on line 30 which maintains the shape of the signal **T**_{**xpfiltered**}, but the level of which is adjusted in dependence on a comparison of the signal **RF**_{**peak**} with the signal **T**_{**xpfiltered**}.

The power level of the signal output by the power stage to the antenna, as defined by the signal **T**_{**xp**} generated by the registers 16, is determined by the proximity of the mobile station to the base station. When the mobile station is close to the base station, the transmitted signal need only be of a relatively low power level. When the mobile station is far from the base station then the transmitted signal needs to be a relatively high level. The level of the signal **T**_{**xp**}, defined by the value stored in the level-register 16b, is determined by the processor 18 which communicates with the base station to determine the necessary power level required in dependence on the distance from the base station.

Thus, the power control loop is required to ensure that the RF power level delivered to the antenna is maintained at the power level indicated by the power/timing template generated by the registers 16 under control of the processor 18. However, the power control loop must also ensure that the ramp signal delivered to the antenna is in the timing frame defined by the power/time template, as set by the registers 16 under the control of the processor 18.

The power control loop 1 must be carefully designed to ensure consistency with the power/time template over a range of possible power levels. As mentioned hereinabove, the value in the ramp-level register 16b in this embodiment may be any one of a number of values. This depends on the accuracy of the D to A converter. At the extremes the comparison and filter stage 12 must therefore be capable of ramping up the signal **T**_{**xp**} to relatively low levels to represent low power levels, or ramping up the signal **T**_{**xp**} to relatively high power levels to represent high power levels, whilst all the time maintaining the timing position of the signal to the antenna within the required timing range for all levels of **T**_{**xp**} defined by the power/timing template.

To ensure stable operation of the power loop it is necessary for the filter of the comparison and filter stage 12 to have a bandwidth dictated by the highest possible loop gain area However, the closed loop bandwidth then becomes too small to generate low power levels at the right position in the GSM power/time template, i.e. for low power levels the loop response time becomes too long.

To deal with this range of power levels there is apparently a conflict of performance requirements for the comparison and filter stage 12. At high power levels, to ensure loop stability, the loop filter of the comparison and filter stage 12 must have a narrow well-defined low-pass bandwidth. However at low power levels, a narrow low-pass bandwidth may introduce timing delays due to poor filter response. Therefore at low power levels, to ensure the response time of the filter is not too long, a wider low-pass bandwidth is desired.

There is thus a trade-off in bandwidth between low and high power levels, such that the comparison and filter stage 12 of Figure 1 has a limit for reliable performance. The need for a relatively narrow bandwidth for high power levels means that for low power signals there comes a point where the response time of the filter is too long compared with the time that is available for the power/time template, and the limit of performance of a conventional GSM RF power control loop is reached.

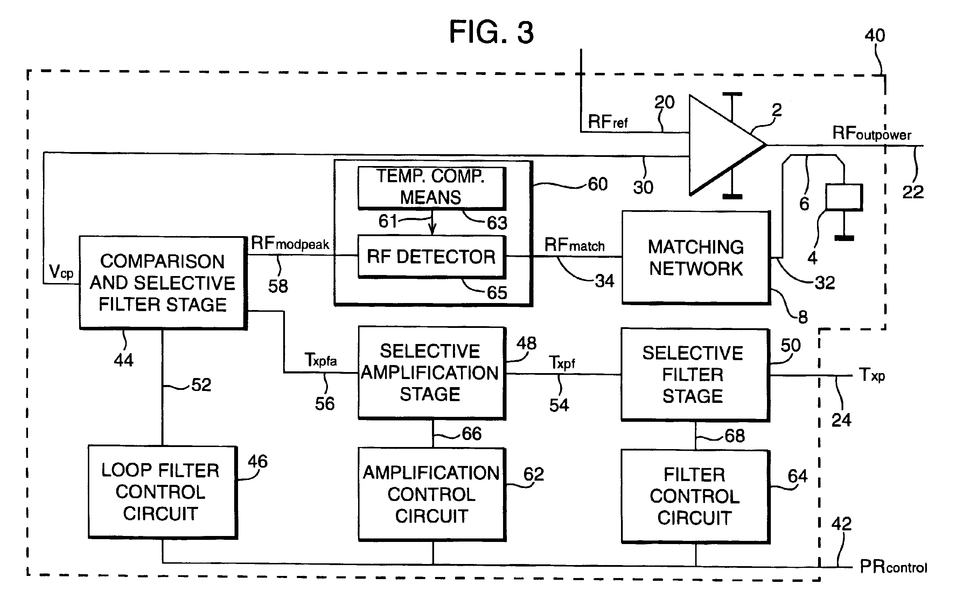

**Figure 3** shows a block schematic of an improved power control loop circuit 40 for a GSM. The same reference numerals are used in Figure 3 for those elements and signals that are identical to elements of Figure 1.

The power control loop 40 shown in Figure 3 outputs the RF output power signal **RF**_{**outpower**} on line 22, and receives as inputs the signal **T**_{**xp**} and **RF**_{**ref**} on lines 24 and 20 respectively. In addition the power control loop of Figure 3 receives a power range input control signal **PR**_{**control**} on line 42. The signal **T**_{**xp**} is generated, as before, by the processor 18 and registers 16 shown in Figure 1, but for clarity these elements are not shown in Figure 3. The power control loop 40 of Figure 3 also includes power stage 2, directional coupler 6, directional coupler impedance 4, and the matching network 8 of the power control loop of Figure 1.

The improved power control loop 40 additionally comprises: a comparison and selective filter stage 44 (corresponding to the comparison and filter stage 12 of Figure 1), a modified RF detector stage 60 (corresponding to the RF detector stage 10 of Figure 1), a selective filter stage 50 and a selective amplification stage 48. The selective filter stage 50 and selective amplification stage 48 correspond to level adjust and filter stage 14 of Figure 1. The improved power control loop 40 further comprises a loop filter control circuit 46, an amplification control circuit 62, and a filter control circuit 64.

The modified RF detector 60 comprises an RF detector 65 and a temperature compensation means 63. The temperature compensation means 63 generates a control signal to the RF detector 65, which may correspond exactly to the RF detector 10.

The loop filter control circuit 46, amplification control circuit 62, and filter control circuit 64 all receive the power range input control signal **PR**_{**control**} on line 42. The loop filter control circuit 46 generates a control signal to the comparison and selective filter stage 44 on line 52 responsive to the signal **PR**_{**control**}. The amplification control circuit 62 generates a control signal to the selective amplification stage 48 on line 66 responsive to the signal **PR**_{**control**}. The filter control circuit 64 generates a control signal to the selective filter stage 50 on line 68 responsive to the signal **PR**_{**control**}.

The comparison and selective filter stage 44 operates, as the comparison and filter stage 12 of Figure 1, to compare the two signals at its inputs and generate an output on line 30 to the power stage 2. The modified RF detector 60, matching network 8, and directional coupler 6 provide a signal indicative of the power level of the output signal **RF**_{**outpower**}.

As described in further detail hereinbelow, the modified RF detector 60 provides a modified peak detected signal **RF**_{**modpeak**} on line 58 to the comparison and selective filter stage 44. The signal **RF**_{**modpeak**} corresponds to the signal **RF**_{**peak**} of Figure 1, other than that it is modified as further discussed hereinafter. Thus the signal **RF**_{**modpeak**} represents the peak RF output power sensed at the output of the power stage 2 on line 22 by the directional coupler 6 matched by the matching network 8.

As will be described further hereinbelow, in the specific embodiment of Figure 3 the signal **T**_{**xp**} on line 24 from the registers 16 is processed by the blocks 50 and 48 prior to forming the input on line 56 to the comparison filter. The blocks 50 and 48 filter and amplify the signal **T**_{**xp**} to generate a filtered and amplified signal **T**_{**xpfa**} on line 56 as described in further detail hereinbelow.

In the specific embodiment of Figure 3, the comparison and selective filter stage 44 comprises a filter element in which one of at least two filter bandwidths may be selected. As described hereinabove, a narrow bandwidth low-pass filter is desired for high power levels and a wide bandwidth low-pass filter is desired for low power levels. Thus, according to the embodiment of Figure 3, the power range input control signal indicates the power range of the signal **T**_{**xp**} on line 24. In this simple embodiment the power range of the signal **T**_{**xp**} is considered to fall into one of two levels, and the signal **PR**_{**control**} will therefore effectively be either on or off to indicate the appropriate level. In other embodiments the power range input signal may indicate one of a large number of power range levels, and may consist of a number of signals.

Thus in this embodiment the power range input control signal **PR**_{**control**} indicates either a low or high power level. Responsive to the power level indicated by the signal **PR**_{**control**}**,** the loop filter control circuit 46 selects one of two bandwidths for the loop filter of the comparison and filter stage 44. For high power levels a narrow bandwidth filter is selected and for low power levels a wider bandwidth filter is selected, by adjusting the cut-off frequency of a low-pass filter. The loop gain is the mathematical multiplication of the gain of the specific circuits in the loop. In this loop we have a non-linear feed forward (RF amplifier) and a non-linear feed back (the RF diode Peak detector). The highest loop gain is found, *in this specific configuration,* around the 27dBm RF output power. In another circuit the distribution of the loop gain may be different. For example the highest loop gain area may be in the power area between OdBm and 5dBm. So it is possible to have more power range levels and **PR**_{**control**} may consist of a number of signals but the distribution of the loop gain is not always high for the high power levels and low for the low power levels).

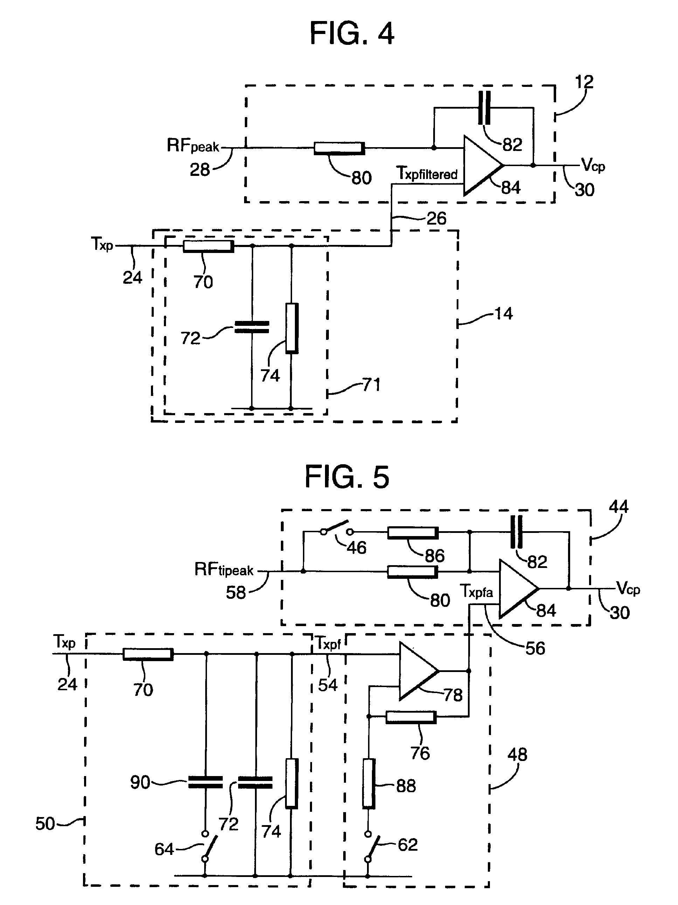

According to this preferred embodiment the loop filter control circuit 46 is a switch which is either open or shut in dependence on the value of the signal **PR**_{**control**}. Opening or closing the switch alters the filter bandwidth of a single filter in the comparison and selective filter stage 44. This operation will be described in more detail with reference to Figures 4 and 5.

Figure 4 illustrates one possible construction of the comparison and filter stage 12 and the level adjust and filter stage 14 of the known power control loop 1 of Figure 1. One skilled in the art will appreciate that Figure 4 illustrates one of many possible constructions of the circuitry shown therein. Figure 5 illustrates a preferred implementation of the comparison and selective filter stage 44, selective amplification stage 48, selective filter stage 50, loop filter control circuit 46, amplification control circuit 62, and filter control circuit 64 of the improved power control loop circuit 40 of Figure 3.

From Figure 4, it can be seen that the conventional comparison and filter stage 12 of Figure 1 comprises an amplifier 84 having two inputs and an output, a resistor 80 and a capacitor 82. The capacitor 82 is placed in series with resistor 80 in order to improve the phase margin. One terminal of the resistor 80 is connected to the signal on line 28, and the other terminal of the resistor 80 is connected to one input of amplifier 84.

The capacitor 82 is connected between the one input of the amplifier 84 and the output of the amplifier 84. The other input of the amplifier 84 receives the signal **T**_{**xpfiltered**} on line 26 of Figure 1. The output of the amplifier 84 forms the signal **V**_{**cp**} on line 30. The amplifiers 78 and 84 are differential amplifiers and one input is subtracting and the other adding.

Referring to Figure 5, it can be seen that the preferred embodiment of the improved power control loop includes comparison and selective filter stage 44 which corresponds to the comparison and filter stage 12 of Figure 4 but with the addition of a switch and a resistor. In this embodiment, the switch is designated by reference numeral 46, as it is actually the loop filter control circuit of Figure 3. The switch 46 is connected in series with a resistor 86, and the series combination of switch 46 and resistor 86 connected in parallel with resistor 80. Opening and closing the switch 46 changes the bandwidth of the loop filter by switching the resistor 86 in and out of the circuit.

Thus, the power control loop response time is improved at low power levels by lowering the value of the resistance in the filter 44 by providing the resistor 86 in parallel with resistor 80 on closure of the switch 46. This provides a larger bandwidth by shifting up the low-pass cut-off frequency of the filter. Thus, for low power levels the switch 46 is closed and for high power levels the switch 46 is opened retaining a narrow bandwidth.

Although the comparison and selective filter stage 44 of Figure 3 is illustrated herein with reference to other additional improvements in the RF power control loop, it will be appreciated that the comparison and selective filter stage 44 and loop control circuit 46 described herein could be introduced into the known power control loop of Figure 1 without substituting the RF detector 10 or the level adjust and filter stage 14. The comparison and selective filter stage 44 independently introduces improvements to the RF power control loop.

Referring back to the power control loop of Figure 1, variations in the temperature of the environment in which the power control loop operates affect the operation of the power control loop. Temperature variations which affect the levels of signals inside the loop do not cause problems. Temperature variations of signals inside the loop are cancelled out by the loop.

The battery voltage supplying the power control loop is affected by temperature variations, but this has no adverse affect on the operation of the loop due to the differential operation of the comparison and filter stage of Figure 1.

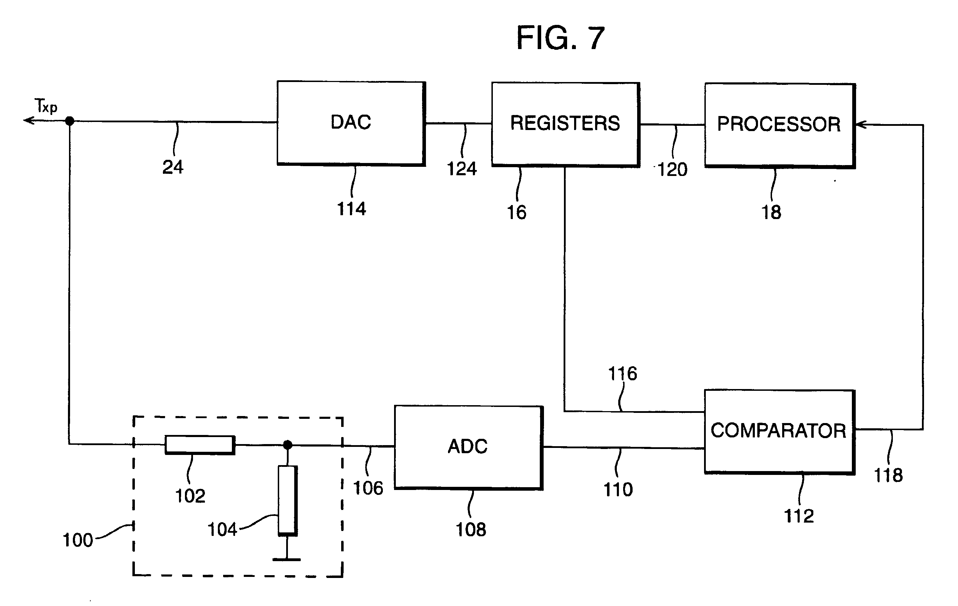

However drift of the power supply will have an effect on the bias current of the diode detector. The output voltage drift over temperature of modern (supply) voltage regulators is most of the time a fixed curve. Also the temperature range will effect the offset voltages and bias currents of the differential amplifiers. Both above described temperature effects can be cancelled out by the resistor arrangement R90, R92 and R98 of Figure 6, as described below.

However the temperature variations affect the level of the signal **T**_{**xp**}. which is generated outside the loop and provides an input to only one side of the comparison and filter stage 12. Thus temperature variations affect the signal **T**_{**xp**}, and consequently affect the level of the signal **RF**_{**outpower**} at the output of the power control loop.

It should also be noted that the temperature effect on the signal **T**_{**xp**} is only a problem when the power control loop operates at low power levels. The logarithmic output power range of the power control loop is from 5dBm to 33dBm. (However, it is actually approximately 35dBm in channel 124 because of the presents of a duplex filter in the transmitter path). At 5 dBm the output power is approximately 3mW and at 33dBm the output power is approximately 2W. At the 5dBm level the output of the RF detector 10 of Figure 1 will be approximately 30mV on top of the detector offset voltage. At the 33dBm level the output of the RF detector 10 of Figure 1 will be approximately 2.65V on top of the detector offset voltage. The fluctuation in temperature can be expected to introduce a variation in the voltage level of **T**_{**xp**} of the order of a few milli volts.

It can be appreciated that a variation of a few milli volts in the level of **T**_{**xp**} will have a significant effect on the output of the comparison and filter stage 12 when the output of the detector 10 is only 30mV. However, when the output of the detector 10 is of the order of 2.65V, a few mV variations on the level of **T**_{**xp**} will have no significant effect on the output of the comparison and filter stage 12. Thus the problem of temperature variations need only be considered at low power levels.

In order to compensate for the variations in the signal level of **T**_{**xp**} at low power levels which affect the level of the signal **RF**_{**outpower**}**,** the circuit of Figure 1 is modified as shown in Figure 3 to introduce a modified RF detector 60.

In Figure 3 the modified RF detector 60 comprises an RF detector 65 connected to receive the signal RF_{match} as an input and to generate the signal RF_{modpeak} as an output. The RF detector 65 also receives a signal on line 61 form the temperature compensation means 63. Other constructions of the modified RF detector 60 are possible, and one particularly advantageous implementation will be described hereinbelow with reference to Figure 6.

Given that the variation of the signal **T**_{**xp**} is the only variable factor with temperature that will affect the level of the output signal **RF**_{**out**}**,** a plot of temperature against voltage level for the signal **T**_{**xp**} can be established experimentally and thus knowledge of how the signal varies with variations in temperature is established. Once this information is established, then the temperature compensation means in the RF detector can be designed to have the same temperature dependent characteristics as the signal **T**_{**xp**}. It will be understood that it is not the absolute levels of the signals at the inputs to the comparison and selective filter stage 12 which determine the output level of the signal **V**_{**cp**}, but rather the difference between those inputs.

Thus, if it is known that the signal **T**_{**xp**} increases or decreases by a certain amount at a given temperature, the temperature compensation means of the RF detector can be designed to the increase or decrease the signal **RF**_{**modpeak**} at its output by the same amount responsive to the same variation in temperature. Thus temperature effects do not introduce a variation in the difference between the two signals at the input to the comparison and selective filter stage 44, and consequently the power control loop 40 behaves as if independent of temperature.

It will be appreciated that if there were other known factors in the power control loop which varied with temperature, and their behaviour was also known, then there variation could also be compensated for in the modified RF detector 60. The temperature compensation means described with may also compensate for known internal hardware variations due to temperature, for example the supply voltage or offset voltages of the differential amplifier.

In the implementation shown in Figure 3, the temperature compensation means 63 responds to variations in environmental temperature to control the RF detector 65 via line 61 to adjust the level of the signal **RF**_{**modpeak**} generated by the RF detector as necessitated by temperature fluctuations. The temperature compensation means may therefore include some means for detecting or responding to the current temperature and accessing, for example, stored values associated with the current temperature to be applied to adjust the signal generated by the RF detector 65.

A preferred implementation of the improved RF detector 60 is illustrated in Figure 6. As shown in Figure 6 the improved RF detector 60 comprises two diodes 94 and 96 and three resistors 90, 92 and 98. The resistor 90 has a first terminal connected to a reference supply voltage **V**_{**rsupply**} and a second terminal connected to the signal **RF**_{**match**} on line 34 at the input to the RF detector. There is a dc blocking capacitor between RF detector and the matching circuit. The resistor 92 has a first terminal connected to the signal **RF**_{**match**} and a second terminal connected to ground. The diode 94 has its anode connected to the signal **RF**_{**match**} on line 34 and its cathode connected to the signal **RF**_{**modpeak**} on line 54. The diode 96 has its anode connected to the signal **RF**_{**modpeak**} at the output of the RF detector on line 54. The resistor 98 has a first terminal connected to the cathode of the diode 96 and its second terminal connected to ground. The diodes 94 and 96 are temperature coupled, preferably from one substrate and in one housing.

The values of the three resistors 90, 92 and 98 are selected to give the required temperature dependent slope for the signal **RF**_{**modpeak**} at the output of the modified RF detector 60 at low power levels. These values are chosen by calculation.

Thus the three resistors 90, 92 and 98 in the RF detector provide the temperature compensation means 63. This is thus a very efficient implementation of the modified RF detector 60.

In order to obtain the necessary temperature dependency of the signal at low power levels, the three resistors 90, 92 and 98 must have a high impedance. This introduces a problem at high power levels in that the level of the signal **RF**_{**modpeak**} becomes too high for comparison with the signal **T**_{**xp**}.

As the control signal **V**_{**cp**} which controls the generation of the signal **RF**_{**out**} is dependent on the difference of the two signals at the input to the comparison and selective filter stage 12 of Figure 1, any factor which distorts one of these signals but not the other prevents correct operation of the power control loop. Thus the fact that the modified RF detector 60 of Figure 6 results in the signal **RF**_{**modpeak**} effectively being amplified at high power levels must be compensated for.

Thus, in the improved RF power control loop with a modified RF detector 60 as illustrated in Figure 6, the RF power control loop is further improved by the introduction of the selective amplification stage 48 and amplification control circuit 62.

In the preferred implementation according to Figures 3 and 6, the selective amplification stage 48 comprises an amplification stage in which one of at least two amplification factors may be selected. By providing control of the amplification factor of the level adjust circuitry which amplifies the signal **T**_{**xp**}, the input to the comparison and selective filter stage can be fine tuned to still further improve the operation of the RF power control loop and overcome the problem at high power levels introduced by the specific implementation of the modified RF detector 60 shown in Figure 6.

At low power levels the level of the signal Txp is acceptable for comparison with the signal **RF**_{**modpeak**} at the output of the RF detector 60, and thus the selective amplification stage 48 is controlled by the amplification control circuit 62 via line 66 to select a amplification factor of unity.

As discussed hereinabove, the absolute levels of the signals at the input to the comparison and selective filter stage 44 are not important. It is the difference between the signals which is important. As at high power levels the signal level at the output of the modified RF output detector of Figure 6 is too high, the selective amplification stage 48 is controlled therefore by the amplification control circuit to amplify the signal **T**_{**xp**} to produce the signal **T**_{**xpfa**}. Thus the signal **T**_{**xp**} is amplified by the known amplification factor introduced at high levels in the modified RF detector of Figure 6. Thus the absolute levels of the two signals are increased to ensure that the difference between the signals is unaffected.

As described above, in the embodiment of Figure 3 the power range input signal indicates either a low or high power level. Responsive to the power level indicated by the signal **PR**_{**control**}, the amplification control circuit 62 selects one of two amplification factors for the selective amplification stage 48.

Thus the improved RF detector 60 of Figure 6 advantageously operates with the selective amplification stage 48 described hereinabove. The voltage of the signal is multiplied by a factor to meet the highest output voltage of the RF detector 60. The possibility of having two or more ranges to control the RF power stage with different accuracy is thus provided. All ranges start from the lowest detectable power range, which is important to put the RF power burst in the right place of the GSM power/time template. The RF power range can be set before a RF power burst has been initialised.

According to this preferred embodiment the amplification control circuit 62 is a switch which is either opened or shut in dependence on the value of the signal **PR**_{**control**}. Opening or closing the switch alters the amplification factor of the selective amplification stage 48. This operation will be described in more detail with reference to Figures 4 and 5.

From Figure 4, it can be seen that the conventional level adjust and filter stage 14 of Figure 1 comprises a filter stage 71 comprising a capacitor 72 and resistors 70 and 74. The output of the level adjust and filter stage 14 forms the signal **T**_{**xpfiltered**} on line 26. In the filter stage the resistor 70 is connected in series between the signal **T**_{**xp**} on line 24 and the output of the filter. The capacitor 72 is connected, in parallel with the resistor 74, between the output of the filter and ground.

Referring to Figure 5, it can be seen that in the preferred embodiment of the invention the level adjust and filter stage 14 of Figure 1 is improved, relative to the implementation of Figure 4, by inclusion of an amplification stage 73 including an amplifier 78 and resistor, and an additional resistor 88 and a switch 62. The switch is designated as numeral 62 since it represents the amplification control circuit 62 of Figure 3. The resistor 88 is connected in series with the switch 62, and the series arrangement of switch 62 and resistor 88 connected between the other input of the amplifier 78 and ground. The amplification factor of the selective amplification stage 48 is selected according to whether the switch 62 is open or closed, by switching the resistor 88 in and out of the circuit 48.

The temperature influence is highest at low RF output power ranges because of the low DC output signal of the detector generated at the output of the RF detector 10 of Figure 1. In order to get a stable low RF output power signal in a large temperature range, special precautions need to be taken in the power control loop circuit. Since the temperature range of a GSM system is large, it is important to have a temperature compensation mechanism in place for all RF output power areas.

In the ETS GSM900 standard the power control range is large, having nineteen possible different power levels. That is, the level of the ramp-level register 16 can output one of nineteen different values, providing a RF output power signal from the power stage 2 of one of nineteen different levels. Of course, any number of different power levels could be provided for in different applications, the only restriction being the size of the ramp-level register 16b. The selective amplification stage 48 may be provided with a number of different amplification factors corresponding to the number of possible power levels.

An alternative technique for compensating for temperature variation in the reference signal **T**_{**xp**} is illustrated by Figure 7. Figure 7 illustrates those elements required to implement this technique. Like reference numerals are used to describe like elements and connections in any preceding Figures.

Referring to Figure 7 the power control loop of Figure 1 is adapted to include a temperature compensation means for the signal **T**_{**xp**}. The signal **T**_{**xp**} is generated from the registers 16 via a digital-to-analogue converter which converts the voltage levels stored in the registers 16 and output on lines 124 to the signal **T**_{**xp**} on line 24. The voltage levels stored in the registers 16 are output on lines 124 under the control of control signals from the processor 18 on lines 120. The generated signal **T**_{**xp**} on line 24 is fed to a level detection circuit 100.

The output of the level detection circuit on line 106 forms an input to an analogue-to-digital converter 108, which in turn presents its output on line 110 to a comparator 112. The comparator additionally receives the stored reference level associated with the current level of the signal **T**_{**xp**} on lines 116 direct from the registers 16. The output of the comparator 112 forma an input to the processor 18 via lines 118. The processor 18 is connected to the register 16 via a plurality of control lines 120

The level detector 100 comprises first and second resistors 102 and 104. The resistor 102 has one terminal connected to the signal **T**_{**xp**} and the other terminal connected to the output 106 of the level detector. The resistor 104 has one terminal connected to the output 106 of the level detector 100 and the other terminal connected to ground. Resistors 102 and 104 are necessary for the hardware in block 108. Other scenarios are conceivable.

As discussed earlier, the processor 18 loads the registers 16 with the digital values corresponding to the signal level of **T**_{**xp**} required. Under the control of the processor 18, the stored digital values are output from the registers 16 on lines 124 to the digital-to-analogue converter 114. The digital-to-analogue converter 114 outputs the analogue signal on line 24 forming the signal **T**_{**xp**} and representing the digital value output form the registers 16.

In environments were the temperature varies beyond a normal level, the analogue signal may vary from that which actually represents the value in the registers 16. In a hot environment the value of **T**_{**xp**} may be increased, and in a cold environment the value of **T**_{**xp**} may be reduced.

The thus generated analogue signal **T**_{**xp**} is fed back to the input of the detector 100. The detector 100 generates a signal on line 106 representing the level of the signal **T**_{**xp**}, which is converted by the analogue-to-digital converter 108 to produce a digital signal on lines 110 representing the level of the signal **T**_{**xp**}. The comparator 112 receives the signal on line 110 and compares it to the digital value stored in the registers 16 and output on lines 116. If there is no temperature influence on the signal **T**_{**xp**}, then the digital signals on lines 110 and 116 will be equal. If there is a temperature effect on **T**_{**xp**} then the signal on line 110 will vary either above or below the signal on line 116. The result of the comparison of the signals on lines 110 and 116 is output by the comparator on lines 118 to the processor 18.

Responsive to the difference signal on line 118, the processor 18 updates the value stored in the registers 16. If the signals are the same the difference signal is retained unchanged.

The processor 18 knows the values of the levels for **T**_{**xp**} stored in the registers 16. Any variation in the level of **T**_{**xp**} detected on line 110 will be the result of temperature variations. The processor can determine the difference between the value of **T**_{**xp**} stored in the register 16 and the detected value to determine the temperature effect on **T**_{**xp**} and adjust the level of **T**_{**xp**} stored in the register 16 to compensate for the temperature effect.

Thus, if the measured value of **T**_{**xp**} is 2mV higher than the value the processor has stored in the registers 16, the processor knows that the effect of the current temperature is to decrease the level of **T**_{**xp**} by 2mV. The processor can reduce the levels of **T**_{**xp**} stored in the registers 16 by 2mV to ensure that the level of **T**_{**xp**}, after temperature effects, is the correct level.

Preferably the calibration is performed when no output power is being generated, for example during a receive operation in a mobile telephone.

The RF power control loop may be still further improved by the introduction of the selective filter stage 50 and filter control circuit 64 of Figure 3.

The timing frame of the signal delivered to the antenna in Figure 1 is also dependent on the filter of the level adjust and filter stage 14. The processor 18, which is used to construct the initial input signal **T**_{**xp**}, typically updates the rising/falling edge of the initial input signal **T**_{**xp**}. every 2µs. The up and down ramps of the power/timing template generated by the registers 16 are thus digital 'staircases'. The filter in the level adjust and filter stage 14 is used to smooth the staircase and also affects the signal tracking behaviour of the power control loop.

In order to provide more adjustment possibilities for the low and high power areas the cut-off frequency of the filter in the level adjust and filter stage 14 of Figure 1 can be changed.

In the preferred embodiment of the invention according to Figure 3, the selective filter stage 50 comprises a filter element in which one of at least two filter bandwidths may be selected. By providing control of the bandwidth of the filter that filters the signal **T**_{**xp**}, the signal at the input of the comparison and selective filter stage can be fine-tuned to further improve the operation of the RF power control loop.

As described above, in the embodiment of Figure 3 the power range input control signal **PR**_{**control**} indicates either a low or high power level. Responsive to the power level indicated by the signal **PR**_{**control**}, the filter control circuit 64 selects one of two bandwidths for the selective filter stage 50. Thus the most appropriate bandwidth is selected to ensure adherence to the power/time template.

According to this preferred embodiment the filter control circuit 64 is a switch which is either opened or shut in dependence on the value of the signal **PR**_{**control**}. Opening or closing the switch alters the filter bandwidth of a single filter in the selective filter stage 50. This operation will be described in more detail with reference to Figures 4 and 5.

Referring to Figure 5, it can be seen that in the preferred embodiment of the invention the filter stage 71 of the level adjust and filter stage 14 of Figure 1 is improved, relative to the implementation of Figure 4, by inclusion of an additional capacitor 90 and a switch. The switch is designated as numeral 64 since it represents the filter control circuit 64 of Figure 5. The capacitor 90 is connected in series with the switch 64, and the series arrangement of switch 64 and capacitor 90 connected in parallel with the capacitor 72. The bandwidth of the selective filter 50 is selected according to whether the switch 64 is open or closed, by switching the capacitor 90 in and out of the circuit 50.

As shown in Figure 6, a supply block 101 supplies the reference supply voltage **V**_{**rsupply**} from a voltage supply. The supply block 101 is controlled, in a preferable implementation of the preferred embodiment, by a control signal 103 which is active only during a transmission bursts of the mobile station. Thus, when a transmission burst is not implemented the reference supply voltage **V**_{**rsupply**} is disconnected from the first terminal of resistor 90.

When the reference supply voltage **V**_{**rsupply**} is disconnected, the RF detector circuit is powered-off and no output generated on line 54 as the signal **RF**_{**modpeak**}. Consequently, power consumption is saved. The processor 18 may provide the control signal 103, which selectively provides the reference supply voltage **V**_{**rsupply**} to the RF detector.

In fact, the supply block 101 is used to supply all the blocks in the power control loop except the RF power stage 2.

In the foregoing description a number of improvements to the conventional RF power control loop have been described. It should be appreciated that each one of these improvements may be introduced into the conventional RF power control loop either in isolation or in combination with others to give improvements to the performance of the conventional power control loop. There is no requirement for all improvements to be introduced simultaneously, although doing so provides a much-improved system over the conventional system.

## Claims

1. An RF power control loop (40) comprising:
a power amplifier (2) for producing at an output (22) an RF output power signal (RF_{outpower});
detection means (4, 6, 8, 60) having an input coupled to the RF output power signal (RF_{outpower}) and for generating at an output (58) a detection signal (RF_{modpeak}) indicative of the RF power level of the RF output power signal (RF_{outpower});
reference means (48, 50, 16, 18) for generating a reference signal (T_{xpfa}) indicative of the required power level of the RF output power signal (RFₒᵤₜ) to be output by the power amplifier (2);
comparison means (44) connected to receive the detection signal (Rf_{modpeak}) and the reference signal (T_{xpfa}) and for outputting a control signal (V_{cp}) to the power amplifier (2), wherein the control signal (V_{cp}) adjusts the RF power level of the RF output power signal (RF_{outpower}) in dependence on the difference between the reference signal (T_{xpfa}) and the detection signal (RF_{modpeak}),
and wherein the comparison means (44) includes a loop filter having at least two selectable bandwidths, the bandwidths of the loop filter being selected responsive to the required power level of the RF output power signal (RF_{outpower}).

2. The RF power control loop (40) of claim 1 in which the comparison means (46) includes switching means (46) responsive to a power control signal (PR_{control}) for selecting the bandwidth of the loop filter.

3. The RF power control loop (40) of claim 1 or claim 2 wherein the reference signal (T_{xpfa}) varies in response to a variation in temperature in a known manner, and the detection means (60) further includes temperature compensation means (63) adapted to vary the detection signal in the same known manner responsive to a variation in temperature.

4. The RF power control loop (40) of claim 3, wherein the detection means (60) comprises:
a first resistor (90) having a first terminal connected to a reference supply voltage and a second terminal connected to the input (34);
a second resistor (92) having a first terminal connected to the input (34) and a second terminal connected to ground,;
a first diode (94) having its anode connected to the input (34) and its cathode connected to the output (54);
a second diode (96), temperature coupled with the first diode (94), having its anode connected to the output (54); and
a third resistor (98) having a first terminal connected to the cathode of the second diode (96) and a second terminal connected to ground,
wherein the temperature compensation means (63) is provided by adapting the ratio of the values of the first (90), second (92) and third (98) resistors.

5. The RF power control loop (40) of claim 3 or claim 4 further comprising amplification means (48) for selectively amplifying the reference signal, wherein the amplification means (48) has at least two selectable amplification factors, the amplification factor of the amplification means (48) being selected responsive to the required power level of the RF output power signal.

6. The RF power control loop (40) of claim 5 in which the amplification circuitry (48) includes switching means (62) responsive to a power control signal (PR_{control}) for selecting the amplification factor.

7. The RF power control loop (40) of claim 5 or claim 6 in which the amplification factor is increased if the required power level of the RF output power signal is increased.

8. The RF power control loop (40) of any preceding claim further comprising means (100) for selectively supplying the reference supply voltage (V_{rsupply}).

9. The RF power control loop (40) of any preceding claim in which the reference means for generating the reference signal comprises:
storage means (16) for storing a reference level corresponding to the required power level of the RF output signal;
signal generating means (114) connected to the storage means (16), for generating an intermediate reference signal based on the stored reference level;
reference comparison means (112) for comparing the level of the intermediate reference signal with the stored reference level; and
control means (18) for generating a modified reference level to cancel the difference between the levels of the intermediate reference signal and the stored reference signal, and for replacing the stored reference level with the modified reference level, wherein the signal generating means generates the reference signal based on the stored modified reference level.

10. The RF power control loop of claim 9, wherein the difference between the detected reference level and the stored reference level is the result of a temperature effect on the reference signal. The RF power control loop of claim 9 or claim 10, wherein the reference comparison means (112) additionally includes reference detection means (100) for detecting the level of the intermediate reference signal.

11. The RF power control loop (40) of any preceding claim further comprising a filter (50) for filtering the reference signal, wherein the filter (50) has at least two selectable bandwidths, the bandwidth of the filter (50) being selected responsive to the required power level of the RF output power signal (RF_{outpower}).

12. The RF power control loop (40) of claim 12 in which the filter (50) includes switching means (64) responsive to a power control signal (PR_{control}) for selecting the bandwidth of the filter (50).

13. A method of controlling the RF power level of an RF output power signal (RF_{outpower}), comprising:
generating an RF output power signal (RF_{outpower});
detecting the RF power level of the RF output power signal (RF_{outpower});
generating a detection signal (RF_{modpeak}) indicative of the detected RF power level;
comparing the detection signal (RF_{modpeak}) and a reference signal (T_{xpfa}) indicative of the required power level of the RF output power signal (RF_{outpower});
adjusting the RF power level of the RF output (RF_{outpower}) signal in dependence on the difference between the detection signal (RF_{modpeak}) and the reference signal (T_{xpfa}),
wherein the comparison step further includes a filtering step, the filtering step applying one of at least two selectable bandwidths in dependence on the required power level of the RF output power signal (RFₒᵤₜ).

14. The method of claim 14 wherein the reference signal (T_{xpfa}) varies in response to a variation in temperature in a known manner, the method further comprising the step of varying the detection signal (RF_{modpeak}) in the same known manner responsive to a variation in temperature.

15. The method of claim 14 or claim 15, wherein the step of detecting the RF power level of the RF output signal is carried out by an RF detector comprising:
a first resistor (90) having a first terminal connected to a reference supply voltage and a second terminal connected to an input coupled (34) to the output RF power signal;
a second resistor (92) having a first terminal connected to the input (34) and a second terminal connected to ground,;
a first diode (94) having its anode connected to the input (34) and its cathode connected to an output (54);
a second diode (96), temperature coupled with the first diode (94). having its anode connected to the output (54); and
a third resistor (98) having a first terminal connected to the cathode of the second diode (96) and a second terminal connected to ground,
wherein the step of varying the detection signal in the same known manner comprises determining a ratio of the values of the first (90), second (92) and third (98) resistors.

16. The method of claim 16 further comprising the step of selectively amplifying the reference signal (T_{xpfa}) by one of at least two amplification factors in dependence on the required power level of the RF output signal.

17. The method of claim 17 in which the amplification factor is increased if the required power level of the RF output power signal is increased.

18. The method of any one of claims 12 to 18 to wherein the step of generating the reference signal comprises:
storing a reference level corresponding to the required power level of the RF output signal;
generating an intermediate reference signal corresponding to the stored reference level;
detecting the level of the intermediate reference signal;
comparing the detected level of the intermediate reference signal to the stored reference level;
responsive to a difference between the stored and intermediate reference levels, replacing the stored reference level with a modified reference level to compensate for the difference between the stored and intermediate reference levels; and
generating the reference signal corresponding to the modified stored reference level.

19. The method of claim 19, wherein the difference between the stored and intermediate reference levels is caused by temperature effects on the intermediate reference signal.

20. The method of any one of claims 14 to 20 further comprising the step of filtering the reference signal (T_{xpfa}), the filtering step applying one of at least two selectable bandwidths in dependence on the required power level of the RF output power signal (RF_{outpower}).

21. A GSM mobile communication system including the RF power control loop of any one of claims 1 to 13.

22. A method of operating a GSM mobile communication system including the steps of any one of claims 14 to 21.
